(19) Europäisches Patentamt
European Patent Office
Office européen des brevets

(11) **EP 3 422 387 B1**

(12) **FASCICULE DE BREVET EUROPEEN**

(45) Date de publication et mention
de la délivrance du brevet:
**27.11.2019 Bulletin 2019/48**

(51) Int Cl.:
***H01J 37/317*** *(2006.01)*

(21) Numéro de dépôt: **18178560.1**

(22) Date de dépôt: **19.06.2018**

(54) **ETALONNAGE DE PETITS MOTIFS ELEMENTAIRES EN LITHOGRAPHIE ELECTRONIQUE A FAISCEAU FORME**

KALIBRIERUNG KLEINER ELEMENTARMOTIVE IN DER ELEKTRONENSTRAHLLITHOGRAFIE MIT GEFORMTEM STRAHL

CALIBRATION OF SMALL BASIC PATTERNS MADE BY SHAPED ELECTRONIC BEAM LITHOGRAPHY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.06.2017 FR 1755863**

(43) Date de publication de la demande:
**02.01.2019 Bulletin 2019/01**

(73) Titulaire: **Commissariat à l'Energie Atomique et aux Energies Alternatives
75015 Paris (FR)**

(72) Inventeurs:
• **FAY, Aurélien
38500 COUBLEVIE (FR)**
• **CHARTOIRE, Jacky
38100 Grenoble (FR)**

(74) Mandataire: **Priori, Enrico et al
Marks & Clerk France
Immeuble "Visium"
22, avenue Aristide Briand
94117 Arcueil Cedex (FR)**

(56) Documents cités:
EP-A1- 3 121 833          DE-A1-102009 049 787
US-A1- 2007 114 453     US-A1- 2007 194 250

**Description**

L'invention porte sur un procédé d'étalonnage de petits motifs élémentaires (« shots ») en lithographie électronique à faisceau formé, ainsi qu'à l'application d'un tel étalonnage à la préparation de données de lithographie électronique.

La lithographie électronique est utilisée pour transférer sur un substrat, avec une résolution élevée, des motifs géométriques (« pattern » en anglais) formant un dessin (« layout » en anglais). Un faisceau d'électrons est utilisé pour insoler une résine déposée sur le substrat suivant le dessin à transférer. La résine insolée subit une transformation chimique qui permet son enlèvement sélectif, exposant certaines régions du substrat qui peuvent alors être gravées ou subir un dépôt ou une implantation ionique (alternativement, c'est la résine non insolée qui est enlevée sélectivement).

L'application principale de la lithographie électronique est la fabrication des masques de photolithographie qui sont utilisés pour la réalisation de circuits intégrés. D'autres applications sont la fabrication directe de circuits intégrés, de composants électroniques ou photoniques, de nanostructures.

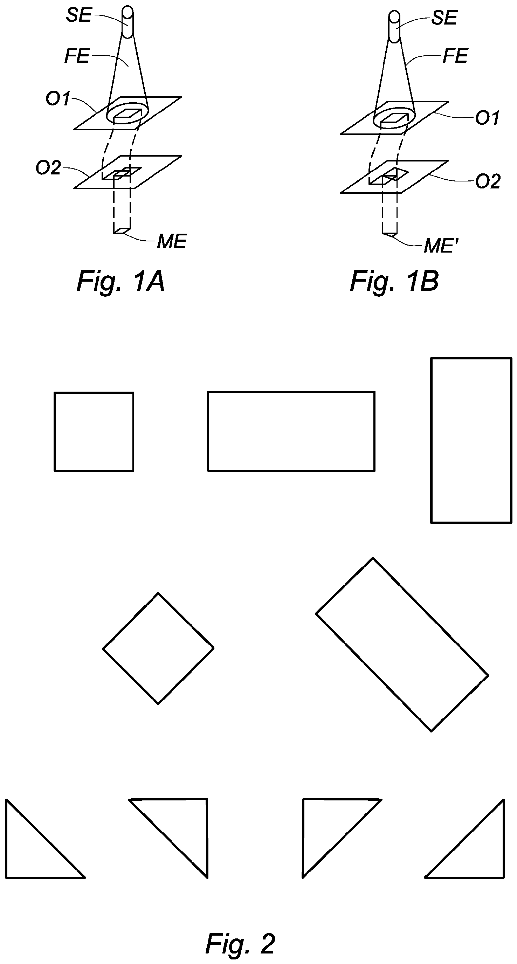

L'exposition de la résine peut être effectuée point par point, au moyen d'un faisceau électronique très étroit, mais cela prend beaucoup de temps. Pour cette raison on a généralement recours à une autre technique, dite « à faisceau formé » (« variable shape beam », ou « VSB » en anglais), dont le principe est illustré par les figures 1A, 1B et 2. Comme on peut le voir sur les figures 1A et 1B, un faisceau d'électrons FE relativement large, généré par une source d'électrons SE, passe à travers deux ouvertures successives O1, O2. La forme du faisceau après latraversée des ouvertures dépend de la forme de ces dernières, qui est variable. On obtient ainsi un motif élémentaire (dans la littérature en langue anglaise on parle de « shot », littéralement « coup ») ME, ME', dont la forme correspond approximativement à celle du faisceau, qui est transféré « en un seul coup » sur le substrat. Dans le cas de la figure 1A, le motif élémentaire ME est carré ou rectangulaire ; dans celui de la figure 1B, le motif élémentaire ME' est triangulaire.

En réalité, la forme et les dimensions du motif élémentaire effectivement transféré sur le substrat ne correspondent pas exactement à celles du faisceau, et dépendent aussi des motifs proches (pour cette raison on parle de « effets de proximité »). Cela est principalement dû à la diffusion des électrons dans la résine et à leur rétrodiffusion par le substrat.

Pour déterminer le motif effectivement transféré sur le substrat on applique à un motif « nominal » :

- un modèle physique, qui représente la répartition des électrons dans la résine, généralement au moyen d'une fonction d'étalement du point (PSF, de l'anglais « Point Spread Function ») ; et
- un modèle de la résine - généralement un simple modèle à seuil : la résine est considérée comme insolée dès lors que la dose électronique qu'elle a reçue dépasse un seuil.

D'une manière connue en soi, cela permet de déterminer des corrections à apporter au motif nominal afin que le motif transféré soit aussi proche que possible de celui souhaité. On parle de « préparation de données » car cette opération aboutit à la création d'un fichier de données qui est fourni à la machine VSB pour contrôler l'exécution du processus de lithographie afin d'obtenir le transfert du motif voulu.

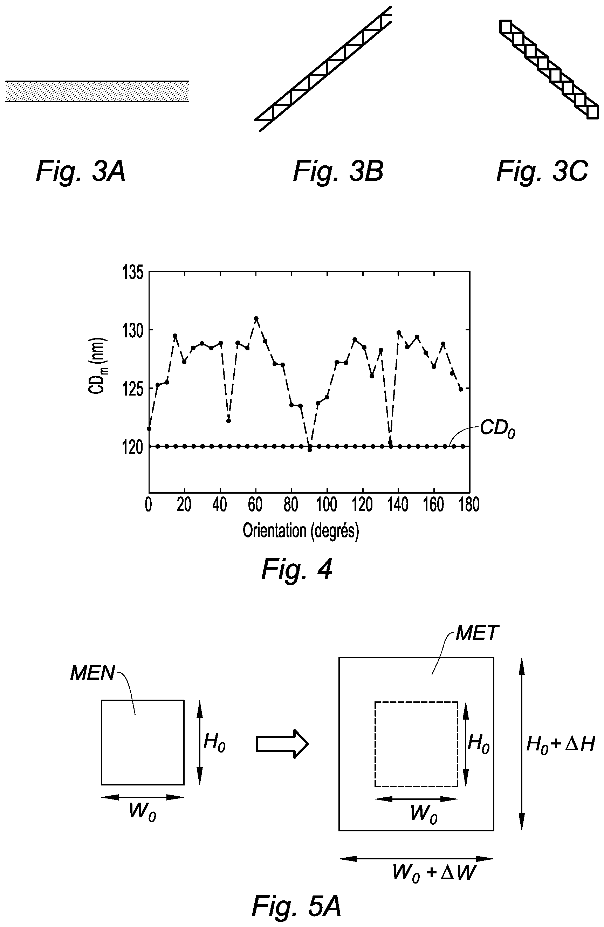

Typiquement, les machines VSB permettent d'obtenir des motifs élémentaires carrés ou rectangulaires, voire en forme de triangle rectangle isocèle, présentant une orientation de 0°, $\pm 45°$ ou 90° par rapport à une direction prise comme référence. Ces différentes formes élémentaires sont illustrées sur la figure 2. On comprend aisément qu'elles permettent de réaliser de manière simple et rapide certains motifs, par exemple des lignes suivant ces quatre orientations prédéfinies. On peut voir par exemple sur les figures 3A et 3B que des lignes horizontales (90° par rapport à la direction de référence, verticale) ou à 45° peuvent être obtenues à partir d'un nombre limité de motifs élémentaires présentant sensiblement la même dimension critique que la ligne elle-même, corrigée pour tenir compte des effets de proximité (la « dimension critique » est la plus petite dimension d'un motif : la largeur d'une ligne, le côté d'un carré..). Une ligne présentant une orientation différente, par contre, doit être décomposée en un nombre plus important de motifs élémentaires sensiblement plus petits que sa dimension critique (largeur) - cela est illustré par la figure 3C.

Or, il est connu que lorsqu'on réalise par lithographie électronique à faisceau formé des motifs élémentaires de très petites dimensions (typiquement 100 nm ou moins), les dimensions des motifs effectivement transférés sur le substrat diffèrent de celles attendues à partir des seuls modèles physique et de la résine. Par exemple, la figure 4 montre la dimension critique (largeur) mesurée $CD_m$ d'une ligne droite de dimension critique nominale $CD_0$ égale à 120 nm, obtenue par lithographie électronique VSB en fonction de son orientation. On peut vérifier que la dimension critique mesurée $CD_m$ s'écarte peu de sa valeur nominale, donnée par un modèle physique (ligne horizontale), pour une orientation de 0°, 45°, 90°, 135°, car dans ces cas il n'est pas nécessaire d'utiliser des motifs élémentaires plus petits que la dimension critique. Par contre, pour des orientations intermédiaires, la dimension critique mesurée de la ligne peut excéder 130 nm, soit une erreur d'environ 10%.

Cet effet est connu de la littérature scientifique :

- H. C. Pfeiffer et al. « Recent Advances in Electron-Beam Lithography for the High-Volume Production of VLSI devices », IEEE transaction on electron devices, Vol. ED-26 4, 663 (1979) ;
- S. Nishimura et al., « Evaluation of Shaping Gain Adjustment Accuracy Using Atomic Force Microscope in Variably Shaped Electron-Beam Writing Systems », J. Appl. Phys. 36, 7517 (1997) ;
- J. Choi et al., « Requirements of e-beam size and position accuracy for photomask of sub-32 nm HP device », SPIE Vol. 7748, 774819-1 (2010) ;
- S. Park et al., « Requirements of the e-beam shot quality for mask patterning of the sub-1X device », SPIE Vol. 9777, 977716-1 (2016).

Cependant, il n'existe pas de méthode permettant de corriger de manière simple et systématique les erreurs associées à l'utilisation de « petits » motifs élémentaires, c'est-à-dire de motifs élémentaires plus petits que la dimension critique du motif à transférer.

L'invention vise à surmonter cette limitation de l'art antérieur. Plus précisément, elle vise à procurer un procédé d'étalonnage des motifs élémentaires en lithographie électronique à faisceau formé utilisable en préparation des données de manière à réduire sensiblement les erreurs associées à l'utilisation de « petits » motifs élémentaires. Elle vise également à procurer au moins un tel procédé de préparation de données.

Par ailleurs, les inventeurs se sont également rendu compte du fait que les erreurs associées à l'utilisation de « petits » motifs élémentaires affectent défavorablement l'estimation du modèle physique de répartition des électrons (PSF). Un mode de réalisation de l'invention permet de remédier à ce problème qui était passé inaperçu jusqu'à présent.

Un objet de l'invention est donc un procédé d'étalonnage de motifs élémentaires en lithographie électronique à faisceau formé comprenant les étapes suivantes :

a. réaliser, par lithographie électronique à faisceau formé, au moins un motif d'étalonnage comprenant des figures géométriques ayant chacune une dimension critique nominale, fractionnées en motifs élémentaires de dimensions plus petites que chaque dite dimension critique nominale, les motifs élémentaires de chaque figure géométrique présentant des dimensions identiques et ceux de figures géométriques distinctes présentant des dimensions différentes ;
b. mesurer la dimension critique réelle de chaque dite figure géométrique ; et
c. appliquer une méthode de régression à partir des dimensions critiques réelles ainsi déterminées pour construire un modèle mathématique exprimant :

- soit une variation de dimensions desdits motifs élémentaires,
- soit une erreur de dose d'exposition desdits motifs élémentaires produisant un effet équivalent à ladite variation de dimensions, en fonction des dimensions des motifs élémentaires.

Selon des modes de réalisation particuliers d'un tel procédé :

- Ladite étape c. peut comprendre les sous-étapes suivantes :

c1. déterminer une expression de ladite variation de dimensions desdits motifs élémentaires ou de ladite erreur de dose en fonction des dimensions des motifs élémentaires et d'une pluralité de paramètres à évaluer ;
c2. Calculer les valeurs desdits paramètres à évaluer par minimisation d'une fonction représentative d'un écart moyen entre les dimensions mesurées lors de l'étape b et celles calculées à l'aide de l'expression déterminée lors de la sous-étape c1.

- Les figures géométriques d'un même motif d'étalonnage peuvent être des lignes droites parallèles entre elles.
- Lesdits motifs élémentaires peuvent être choisis parmi des motifs rectangulaires et des motifs triangulaires.
- Lesdits motifs élémentaires peuvent être en forme de triangle rectangle isocèle, et les figures géométriques d'un même motif d'étalonnage sont de lignes droites parallèles entre elles et à un cathète desdits motifs élémentaires.
- Chaque dite forme géométrique peut être fractionnée en motifs élémentaires identiques, juxtaposés sans recouvrement.
- Lesdits motifs élémentaires peut être en forme de triangle rectangle isocèle, lesdites figures géométriques peuvent être des lignes droites parallèles entre elles et à un côté des motifs élémentaires correspondants, et ledit motif d'étalonnage peut comprendre :
- des lignes formées de deux sous-ensembles de motifs élémentaires identiques en forme de triangle rectangle isocèle juxtaposés sans recouvrement, lesdits sous-ensembles étant superposés avec un décalage spatial ; et
- des lignes formées de motifs élémentaires en forme de triangle rectangle isocèle présentant des orientations complémentaires, juxtaposées sans recouvrement.

- Ledit modèle mathématique peut être un modèle polynomial.

Un autre objet de l'invention est un procédé de préparation de données pour lithographie électronique à faisceau formé comprenant une étape de correction d'une variation de dimensions d'au moins un motif élémentaire d'un dessin à transférer sur un substrat par lithographie électronique à faisceau formé, ladite étape étant mise en œuvre par l'utilisation d'un modèle mathématique exprimant ladite variation, ou une erreur de dose d'exposition produisant un effet équivalent à ladite variation, en fonction des dimensions dudit motif élémentaire ; le procédé comprenant également une étape préalable de détermination dudit modèle mathématique au moyen d'un procédé d'étalonnage tel que défini ci-dessus.
Selon des modes de réalisation particuliers :

- Ledit modèle mathématique peut exprimer ladite variation de dimensions d'au moins un motif élémentaire en fonction de ses dimensions, le procédé comprenant les étapes suivantes :

   i. recevoir, en tant que donnée d'entrée, un dessin à transférer sur un substrat par lithographie électronique à faisceau formé ;
   ii. fractionner ledit dessin en motifs élémentaires et utiliser un modèle physique de répartition des électrons pour effectuer une correction géométrique et/ou en dose d'exposition de chaque dit motif élémentaire ;
   iii. appliquer ledit modèle mathématique pour calculer une variation de dimensions de chaque dit motif élémentaire ;
   iv. calculer, pour chaque dit motif élémentaire, une dose d'exposition corrigée en tenant compte de la variation de dimensions correspondante ; et
   v. appliquer les doses d'expositions corrigées calculées lors de l'étape iv aux motifs élémentaires corrigés, tels que déterminés à l'issue de l'étape ii.

- Ledit modèle mathématique peut exprimer ladite variation de dimensions d'au moins un motif élémentaire en fonction de ses dimensions, le procédé comprenant les étapes suivantes :

   I. recevoir, en tant que donnée d'entrée, un motif géométrique à transférer sur un substrat par lithographie électronique à faisceau formé ;
   II. fractionner ledit dessin en motifs élémentaires et utiliser un modèle physique de répartition des électrons pour effectuer une correction géométrique et/ou en dose d'exposition de chaque dit motif élémentaire ;
   III. appliquer ledit modèle mathématique pour calculer une variation de dimensions de chaque dit motif élémentaire, et modifier lesdits motifs élémentaires pour corriger cette variation ;
   IV. appliquer à nouveau ledit modèle mathématique pour calculer une nouvelle variation de dimensions de chaque dit motif élémentaire, en prenant compte la correction effectuée lors de l'étape III ;
   V. calculer, pour chaque dit motif élémentaire, une dose d'exposition corrigée en tenant compte de la variation de dimensions correspondante calculée lors de l'étape IV ; et
   VI. appliquer les doses d'expositions corrigées calculées lors de l'étape V aux motifs élémentaires tel que modifiés lors de l'étape III.

- Ledit modèle mathématique peut exprimer ladite une erreur de dose d'exposition produisant un effet équivalent à une variation de dimensions d'au moins un motif élémentaire de lithographie électronique en fonction de ses dimensions, le procédé comprenant une étape de correction de ladite erreur de dose d'exposition.

Encore un autre objet de l'invention est un procédé de transfert d'un dessin sur un substrat par lithographie électronique à faisceau formé, comprenant :

- une étape de préparation de données, mise en œuvre par un procédé tel que défini ci-dessus ; et
- une étape de lithographie électronique à faisceau formé utilisant des dimensions et doses d'exposition de motifs élémentaires obtenues par ledit procédé.

Encore un autre objet de l'invention est un procédé d'estimation d'un modèle physique de répartition des électrons dans un procédé de lithographie électronique à faisceau formé, comprenant :

A. le transfert d'un dessin sur un substrat au moyen dudit procédé de lithographie électronique à faisceau formé, ledit dessin étant composé d'une pluralité de motifs élémentaires ;
B. une estimation dudit modèle physique de répartition des électrons par comparaison entre des dimensions simulées et des dimensions mesurées dudit dessin transféré sur le substrat ;

C. la mise en œuvre d'un procédé d'étalonnage tel que défini plus haut pour construire un modèle mathématique exprimant une variation des dimensions desdits motifs élémentaires en fonction desdites dimensions ; et

D. le calcul de nouvelles dimensions simulées du dessin transféré sur le substrat par application dudit modèle mathématique ; et les étapes B. à D. étant mises en œuvre de manière itérative.

D'autres caractéristiques, détails et avantages de l'invention ressortiront à la lecture de la description faite en référence aux dessins annexés donnés à titre d'exemple et qui représentent, respectivement :

- Les figures 5A, 5B et 5C, des variations dimensionnelles de petits motifs élémentaires de formes différentes ;
- Les figures 6A, 6B, 6C, 6D et 6E, le fractionnement en motifs élémentaires de différents motifs d'étalonnage en forme de ligne ;
- Les figures 7A, 7B, 7C, 7D et 7E, des graphiques illustrant la dépendance de la dimension critique d'un motif d'étalonnage (ligne) en fonction des dimensions des motifs élémentaires le composant ;
- Les figures 8A, 8B et 8C, des organigrammes de différents procédés de préparation de données selon des modes de réalisation de l'invention ; et
- La figure 9 un organigramme d'un procédé itératif d'estimation d'un modèle physique de répartition des électrons selon un autre mode de réalisation de l'invention.

La partie gauche de la figure 5A montre un motif élémentaire (ou « shot ») « nominal » MEN de forme rectangulaire dont les côtés, respectivement perpendiculaires et parallèles à la direction de référence (« orientation à 0° »), présentent des longueurs $W_0$ et $H_0$. Le motif réellement transféré sur le substrat, autrement dit l'empreinte du faisceau sur la résine, est désigné par la référence MET et présente des côtés de longueur $W_0+\Delta W_0$ et $H_0+\Delta H_0$. On suppose que le centre de gravité du motif élémentaire transféré est inchangé par rapport à celui du motif nominal, ce qui est vérifié avec une bonne approximation, mais cette hypothèse simplificatrice peut être relâchée facilement. Les écarts $\Delta W_0$ et $\Delta H_0$ peuvent, en principe, être positifs ou négatifs ; Dans la suite, on considérera uniquement le cas où ces écarts sont positifs, ce qui signifie que le motif élémentaire effectivement transféré est plus grand que le motif nominal correspondant, mais cela n'est pas essentiel. Ce qui est important est que ces écarts dépendent des dimensions nominales $W_0$ et $H_0$. On peut ainsi écrire :

$$\Delta W_0 = \Delta W(W_0, H_0)$$
$$\Delta H_0 = \Delta H(W_0, H_0) \tag{1}$$

On fait l'hypothèse que les fonctions exprimant les écarts dimensionnels en fonction des dimensions nominales dépendent d'un nombre fini de paramètres. Par exemple on peut considérer que les fonctions $\Delta W(W, H)$ et $\Delta H(W, H)$ sont polynomiales de degré N, de sorte que l'on peut écrire :

$$\begin{cases} \Delta W(W_0, H_0) = \sum_{i=0}^{N} \sum_{j=0}^{N-i} \chi_{i,j}^0 H_0^i W_0^j \\ \Delta H(W_0, H_0) = \sum_{i=0}^{N} \sum_{j=0}^{N-i} \Lambda_{i,j}^0 H_0^i W_0^j \end{cases} \tag{2}$$

où $\chi^0$ et $\Lambda^0$ sont respectivement les deux matrices (NxN) de coefficients des lois polynomiales de degré N, définissant ce que l'on peut appeler le « modèle des motifs élémentaires » pour le cas d'un rectangle d'orientation 0°.

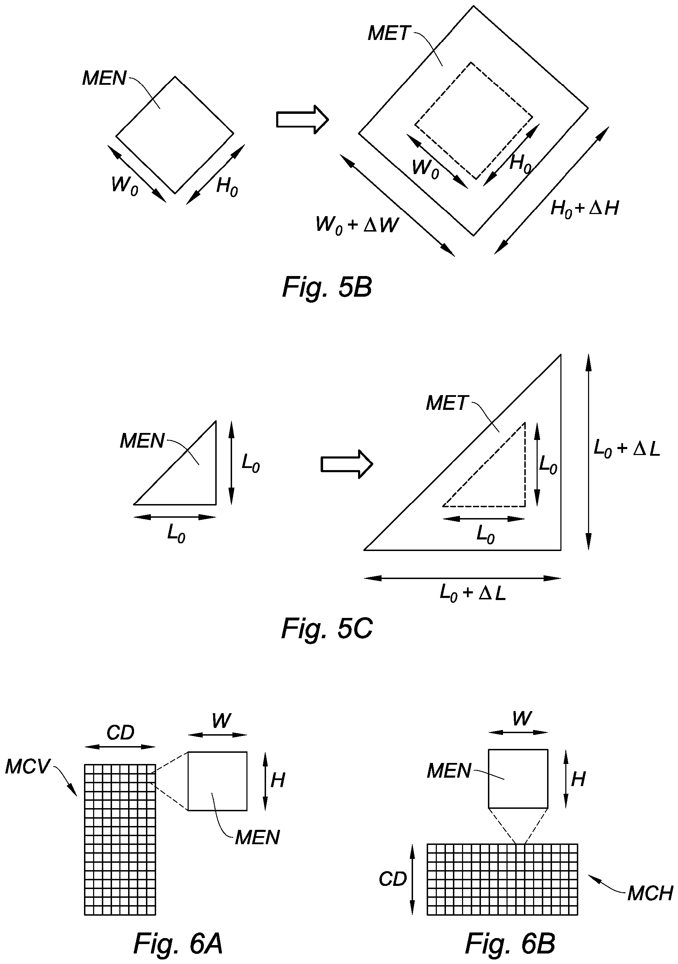

Le cas d'un motif élémentaire rectangulaire orienté à 45° par rapport à la direction de référence (figure 5B) est tout à fait similaire. Le modèle des motifs élémentaires correspondant est défini par deux autres matrices NxN : $\chi^{45}$ et $\Lambda^{45}$.

La figure 5C se rapporte au cas d'un motif élémentaire en forme de triangle rectangle isocèle, présentant un côté (cathète) de longueur nominale $L_0$ et une longueur réelle $L_0+\Delta L_0$. Un modèle polynomial d'ordre N exprimant la variation dimensionnelle $\Delta L_0$ en fonction de la dimension nominale $L_0$ peut donc s'écrire :

$$\Delta L(L_0) = \sum_{i=0}^{N} \Gamma_i L_0^i \tag{3}$$

où $\Gamma$ est un vecteur de coefficients de dimension N. En fait, il existe quatre orientations possibles pour un motif élémentaire triangulaire (voir la partie inférieure de la figure 2), il faut donc définir quatre de ces vecteurs : $\Gamma^1$, $\Gamma^2$, $\Gamma^3$, $\Gamma^4$,

Ainsi, pour un appareil de lithographie électronique VSB présentant les motifs élémentaires de la figure 2, un modèle polynomial d'ordre N des petits motifs élémentaires comprend $4N^2+4N$ paramètres (4 matrices NxN : $\chi^0$, $\Lambda^0$, $\chi^{45}$, $\Lambda^{45}$ et 4 vecteurs Nx1 : $\Gamma^1$, $\Gamma^2$, $\Gamma^3$, $\Gamma^4$). Dans certains cas, il sera possible de simplifier ce modèle, par exemple en prenant $W_0 = \Delta W(W_0)$ et $\Delta H_0 = \Delta H(H_0)$, hypothèse qui réduit le nombre de paramètres à 8N.

Le choix d'un modèle polynomial n'est pas exclusif. Par ailleurs, différentes machines VSB peuvent présenter des motifs élémentaires différents de ceux de la figure 2, ce qui impacte la structure du modèle.

Il est également possible ne pas considérer directement les variations dimensionnelles $\Delta W$, $\Delta H$, $\Delta L$, mais des variations équivalentes $\Delta D$ de la dose D, qui induiraient indirectement ces mêmes variations dimensionnelles. Dans le cas d'un motif élémentaire triangulaire, par exemple, on peut alors écrire :

$$\Delta D(L_0) = \sum_{i=0}^{N} \delta_i L_0^i \qquad (4)$$

Les paramètres $\delta_i$ formant un vecteur $\delta$ à N composantes. Le cas des motifs rectangulaires est tout à fait similaire sauf que, comme dans l'équation 2, le modèle comprend $N^2$ paramètres.

Dans tous les cas, on aboutit à un modèle exprimant une variation dimensionnelle, ou une variation de dose équivalente, en fonction des dimensions nominales d'un motif élémentaire, de sa forme et d'un nombre fini de paramètres. Se pose donc le problème d'estimer ces paramètres.

Pour ce faire, il est nécessaire de transférer sur le substrat des motifs d'étalonnage obtenus à partir de motifs élémentaires de dimensions critiques nominales identiques à l'intérieur d'un même motif d'étalonnage. Dans les modes de réalisation décrits ci-après, les motifs d'étalonnage présentent tous des dimensions critiques nominales identiques, mais cela n'est pas essentiel.

On utilise des motifs d'étalonnage différents pour différents motifs élémentaires.

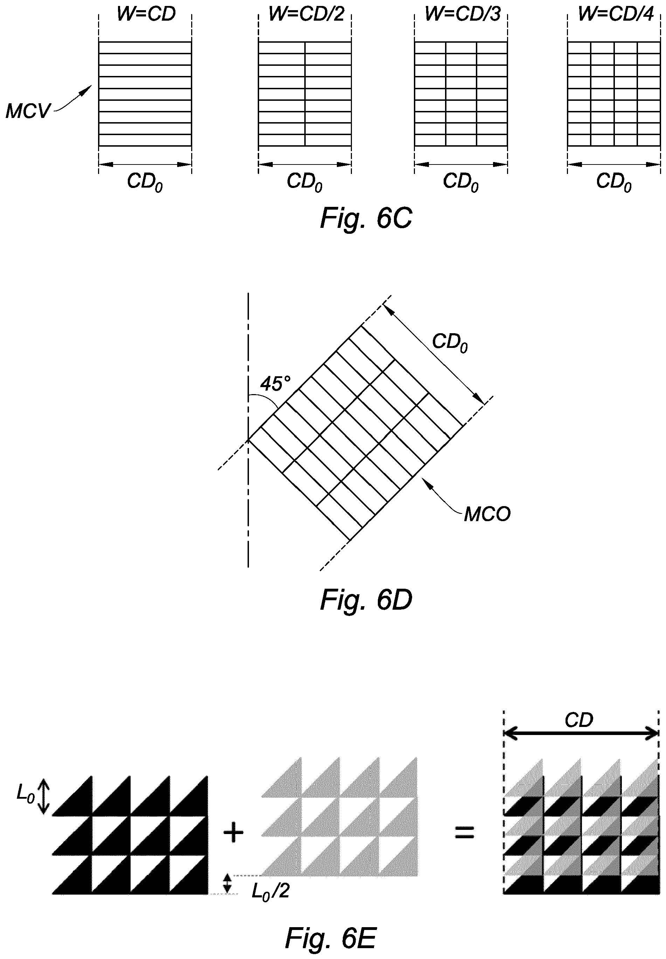

Pour des motifs élémentaires rectangulaires avec une orientation « 0° » (cf. figure 5A), les motifs d'étalonnage sont des lignes verticales MCV ou horizontales MCH de largeur (dimension critique) nominale $CD_0$, fractionnées en motifs élémentaires MEN identiques, de dimensions H et W. La largeur nominale $CD_0$ de chaque ligne est un multiple entier de la largeur (pour les lignes verticales) ou de la hauteur (pour les lignes verticales) des motifs élémentaires constitutifs ; autrement dit, pour les motifs d'étalonnages MCV : $CD_0 = n \cdot W$ et pour les motifs d'étalonnage MCH : $CD_0 = n \cdot H$, n étant un entier. Le cas d'un motif d'étalonnage constitué par une ligne verticale est représenté sur la figure 6A, celui d'un motif en forme de ligne horizontale sur la figure 6B.

En revanche, la hauteur (H) ou la largeur (W) des motifs élémentaires d'une ligne verticale ou horizontale, respectivement, n'a pas de contrainte de quantification spécifique. La largeur et la hauteur maximale des motifs élémentaires sont toutefois limitées par la machine VSB. Il est intéressant de choisir une valeur de $CD_0$ telle que la discrétisation de la largeur ou de la hauteur des motifs élémentaires soit la plus fine possible. Par exemple pour un $CD_0$ de 120 nm, les largeurs entières des motifs élémentaires accessibles sont [120, 60, 40, 30, 24, 20, 15, 12, 10, 8, 6, 5, 4, 3, 2, 1] nm. En pratique, on retiendra les motifs élémentaires dont la largeur est proportionnelle au pas de grille minimal d'un dessin d'entrée de la machine VSB. On remarque que plus la $CD_0$ du motif d'étalonnage est grande, plus le nombre de motifs élémentaires différents possibles répondant aux critères précédents est grand. La figure 6C montre, à titre d'exemple, un motif d'étalonnage en forme de ligne verticale fractionné en motifs élémentaires de hauteur fixe et de largeur W égale à $CD_0$, $CD_0/2$, $CD_0/3$ et $CD_0/4$.

Pour les motifs élémentaires en forme de rectangle orienté à 45° on utilise des motifs d'étalonnage MCO en forme de ligne présentant la même orientation.

Le cas des motifs élémentaires en forme de triangle est plus complexe. En effet, une ligne droite constituée de triangles rectangles identiques et de même orientation ne serait remplie qu'à moitié (voir la partie gauche de la figure 6E). La dose moyenne serait donc la moitié que dans le cas de motifs élémentaires rectangulaires, ce qui fausserait l'étalonnage. Une solution possible consiste à utiliser des triangles complémentaires, mais cela implique d'étalonner conjointement les modèles des motifs élémentaires distincts. Il est donc préférable de superposer deux sous-motifs constitués de triangles identiques juxtaposés et décalés d'une demi-période, c'est-à-dire d'une longueur $L_0/2$. Cela est illustré sur la figure 6E. Chaque sous-motif constitué de triangles identiques présente un taux de remplissage de 50%, tandis que le motif constitué par leur superposition est de 100%. Il est également possible d'utiliser conjointement les deux approches, comme cela sera expliqué en détail plus loin.

D'une manière plus générale, un motif d'étalonnage comprend des lignes dont la direction correspond à une orientation des motifs élémentaires pouvant être produits par l'appareil VSB à étalonner. Une telle ligne peut être constituée uniquement de motifs élémentaires d'un même type (ayant une même forme, une même orientation et des dimensions nominales identiques) ou de motifs élémentaires de même forme et dimensions, mais pouvant avoir des orientations différentes, en particulier opposées.

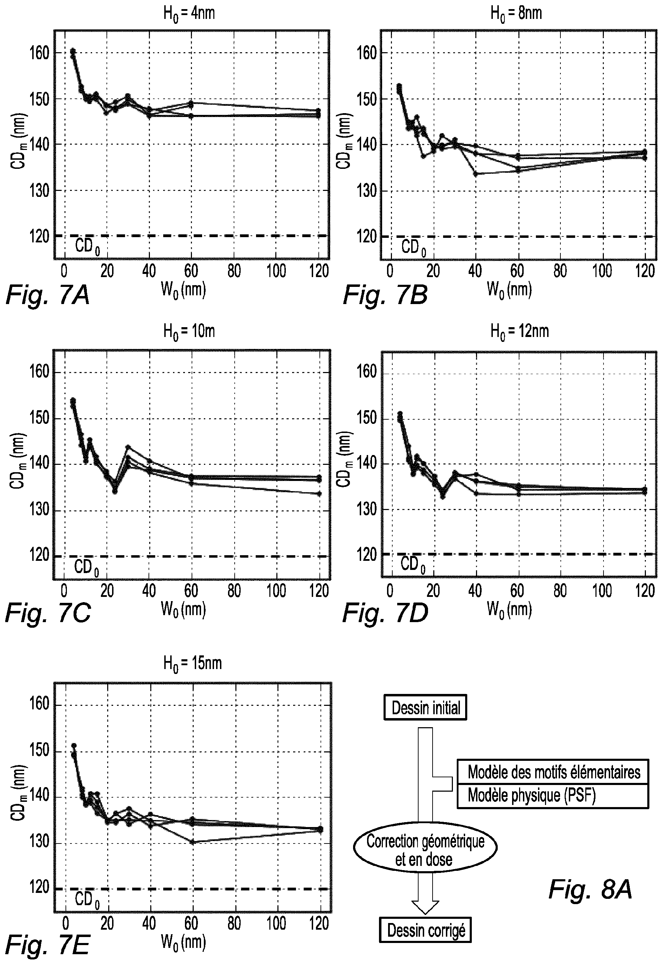

Les motifs d'étalonnage sont d'abord transférés dans la résine, puis leurs dimensions critiques réelles sont mesurées par des méthodes connues, par exemple par microscopie électronique ou microscopie à force atomique. Par exemple, les figures 7A à 7E sont des graphiques des dimensions critiques mesurées, $CD_m$, de motifs d'étalonnage en forme de lignes verticales d'une largeur nominale $CD_0$ de 120 nm, fractionnés en motifs élémentaires rectangulaires ayant des hauteurs $H_0$ de 4 nm (fig. 7A), 8 nm (fig. 7B), 10 nm (fig. 7C), 12 nm (fig. 7D) et 15 nm (fig. 7E) et différentes valeurs de largeur $W_0$ comprises entre 4 nm et 120 nm. On remarque que l'utilisation de motifs d'étalonnage de « grandes » dimensions, constitués de plusieurs « petits » motifs élémentaires, amplifie la variation dimensionnelle que l'on cherche à étalonner. Par exemple, dans le cas d'un motif d'étalonnage fracturé en motifs élémentaires carrés de 4 nm x 4 nm, l'erreur de dimension critique $\Delta CD=(CD_m - CD_0)$ atteint 160 nm -120 nm = 40 nm (soit 30%), alors que la variation de largeur $\Delta W_0$ d'un motif élémentaire isolé serait sub-nanométrique et difficilement quantifiable. Il ne faut pas croire, cependant, que si $CD_0=n \cdot W_0$, alors $\Delta CD=n \cdot \Delta W_0$. La relation entre $\Delta CD$ et $\Delta W_0$(ou $\Delta H_0$, ou $\Delta L_0$) est plus complexe car elle dépend des effets de proximité.

L'étape successive du processus d'étalonnage du modèle des petits motifs élémentaires consiste à calculer la dimension critique attendue, ou « théorique », des motifs d'étalonnage. Pour ce faire il faut d'abord calculer le champ de dose, c'est-à-dire la répartition spatiale des électrons ; cela nécessite l'utilisation du modèle physique ; ensuite la dimension critique est obtenue en appliquant le modèle de résine.

En principe, le champ de dose D(r) pour un motif d'étalonnage est donné par la somme, sur tous les motifs élémentaires, du produit de convolution entre un motif élémentaire $ME_i$ et la fonction d'étalement du point PSF (supposée la même pour tous les motifs élémentaires) :

$$D(\vec{r}) = D_0 \sum_i \int_{ME_i} d\vec{r_S}\, PSF(\|\vec{r} - \vec{r_S}\|) \qquad (5)$$

où $D_0$ est la dose d'exposition de chaque motif élémentaire, $\vec{r}$ et $\vec{r}_s$ des vecteurs position. Lorsque la PSF est exprimée par une somme de gaussiennes (ce qui est fréquent), sa convolution avec un motif élémentaire rectangulaire peut être calculée analytiquement. Dans les autres cas on a généralement recours à un calcul approché par la méthode des éléments finis, c'est-à-dire en approchant l'intégrale de convolution par une somme discrète sur des sous-éléments de chaque motif élémentaire.

Précisément, pour une géométrie rectangulaire, chaque motif élémentaire peut être divisé en sous-éléments virtuels de surface dx·dy. La taille du maillage considéré doit être choisie de telle sorte que la variation de la PSF au sein de chaque cellule du maillage est négligeable. Dans le cas où la largeur ou la hauteur d'un motif élémentaire ne sont pas multiples du pas de grille, les sous-éléments situés aux bordures du motif sont diminuées en conséquence pour ne pas dépasser.

La densité de dose s'écrit comme une double somme sur les motifs élémentaires $ME_i$ et sur leurs sous-éléments j :

$$D(\vec{r}) = D_0 \sum_{i,j} ME_{ij}\, PSF(\|\vec{r} - \vec{r_{ij}}\|), \qquad (6)$$

où $ME_{ij}$ correspond à l'aire du sous-élément j du motif élémentaire i et $\vec{r_{ij}}$ et le vecteur de positionnement d'un point de ce sous élément pris comme origine. Dans le cas d'un motif élémentaire triangulaire, le calcul du champ de dose peut être réalisé numériquement en discrétisant le motif élémentaire en des sous-éléments rectangulaires ou triangulaires dont la taille caractéristique est petite par rapport à la variation de la PSF.

Une fois le champ de dose calculé, l'on applique le modèle de la résine. Ce dernier est le plus souvent du type à seuil ; il s'agit alors de déterminer le contour défini par $D(\vec{r})=D_{seuil}$, où $D_{seuil}$ est le seuil d'exposition, au-delà duquel la résine est considérée comme parfaitement insolée.

A cause du fractionnement du motif d'étalonnage, ce contour n'est généralement pas droit, mais présente des ondulations ; la dimension critique théorique $CD_{theo}$ est donc obtenue en calculant la largeur moyenne du motif sur toute la longueur de la ligne (ou, au minimum, sur une longueur beaucoup plus grande que l'échelle des ondulations).

Lors du calcul de la dimension critique théorique $CD_{theo}$, il ne faut pas se limiter à considérer les motifs élémentaires nominaux, mais leur appliquer les variations dimensionnelles introduites par le modèle des petits motifs élémentaires à étalonner afin de trouver, par une méthode de régression, les valeurs optimales des paramètres de ces modèles - c'est-à-dire celles qui minimisent l'écart entre les dimensions critiques théoriques et mesurées. Plus précisément, le calcul de $CD_{theo}$ doit être répété pour toutes les dimensions nominales des motifs élémentaires utilisés dans la partie expérimentale du procédé d'étalonnage et, pour chaque dimension ou combinaison de dimensions nominales (par exemple $W_0$ et $H_0$), en attribuant différentes valeurs aux paramètres du modèle des petits motifs élémentaires. Ainsi, dans le cas de motifs élémentaires rectangulaires, pour chaque paire de dimensions nominales ($W_0$, $H_0$) utilisée

pour la réalisation de motifs d'étalonnage, il faut explorer l'espace de paramètres $(\chi, \Lambda)$, calculer les variations dimensionnelles $\Delta W$, $\Delta H$ correspondant à chaque ensemble de paramètres, puis la dimension critique $CD_{theo}$ correspondante. Le plus souvent, un échantillonnage complet de l'espace de paramètre serait trop coûteux en termes de temps de calcul. Ainsi, de manière préférentielle, l'on utilisera des méthodes classiques, telles que l'algorithme de descente du gradient, pour balayer partiellement et de manière optimale cet espace (dans le cas d'une descente de gradient, par exemple, seuls les paramètres au voisinage d'un chemin de convergence sont pris en compte).

Typiquement, on procèdera par minimisation d'une fonction de coût telle qu'une erreur quadratique moyenne. Dans le cas de motifs élémentaires rectangulaires, l'étalonnage consiste alors à trouver les matrices de coefficients $\chi$ et $\Lambda$ qui minimisent :

$$f_{\text{rectangle}} = \sum_i \left| CD_{\text{theo}} \left( W_i^0 + \Delta W_i(W_i^0, H_i^0), H_i^0 + \Delta H_i(W_i^0, H_i^0) \right) \right.$$

$$\left. - CD_m(W_i, H_i) \right|^2. \tag{7}$$

où l'indice i désigne un motif élémentaire d'un motif d'étalonnage spécifique.

Les lois polynomiales du modèle peuvent être contraintes à partir de considérations physiques ce qui permet un meilleur conditionnement du problème d'optimisation :

- Comme cela a été évoqué plus haut, on peut supposer que la variation $\Delta W$ ne dépend pas de la hauteur H des motifs élémentaires mais de W seulement. Le même raisonnement peut être appliqué à $\Delta H$ qui ne dépend pas de W mais de H seulement. De sorte que :

$$\begin{cases} \Delta W(W_0) = \displaystyle\sum_{j=0}^{N} \chi_j W_0^{\,j} \\ \Delta H(H_0) = \displaystyle\sum_{i=0}^{N} \Lambda_i H_0^{\,i} \end{cases} \tag{8}$$

- Le modèle concerne les petits motifs élémentaires. Il existe donc une taille de référence $W_{ref} \times H_{ref}$ à partir de laquelle la dimension critique mesurée est intégralement expliqué par le modèle physique. Il est donc possible de considérer que pour une taille $W_0 \geq W_{ref}$ et $H_0 \geq H_{ref}$, les variations $\Delta W$ et $\Delta H$ sont nulles.
- Une contrainte supplémentaire revient à imposer la dérivée des lois $\Delta W(W_0)$ et $\Delta H(H_0)$ à zéro aux tailles de référence $W_{ref}$ et $H_{ref}$.

Pour les motifs triangulaires, il est possible de procéder de manière tout à fait équivalente en utilisant le motif d'étalonnage de la figure 6E. Il est également possible d'étalonner de manière conjointe des paires de motifs complémentaires, par exemple (triangle rectangle isocèle avec angle droit en bas à gauche - triangle rectangle isocèle avec angle droit en haut à droite). Pour ce faire, on réalise deux motifs d'étalonnage du type de la figure 6E pour les deux sortes de triangles, et un motif additionnel utilisant des paires de triangles complémentaires forment des carrés. On obtient ainsi trois fonctions de coût élémentaires que l'on somme, éventuellement de manière pondérée, pour trouver une fonction de coût globale dont la minimisation fournit deux vecteurs de paramètres $\Gamma^1$, $\Gamma^2$. On peut opérer de la même façon pour extraire les vecteurs de paramètres $\Gamma^3$, $\Gamma^4$ associés aux deux autres motifs triangulaires complémentaires.

On a considéré ici le cas d'un modèle des motifs élémentaires exprimé en termes de variations dimensionnelles. Dans le cas d'un modèle exprimé en termes de variation de dose (équation (4)), il suffit de remplacer dans les équations (5) ou (6) la valeur de dose $D_0$ par celle fournie par le modèle des motifs élémentaires et exprimée en fonction des paramètres à déterminer.

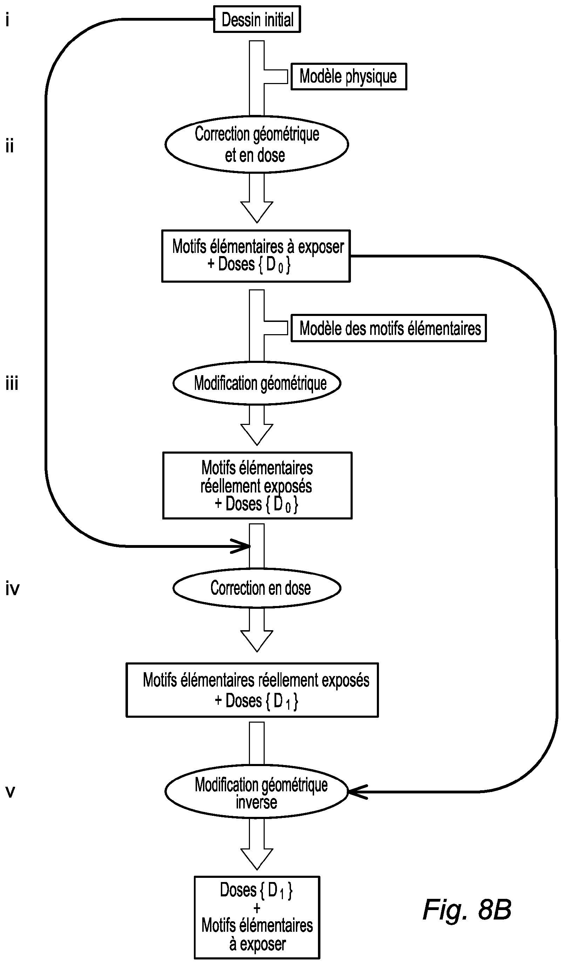

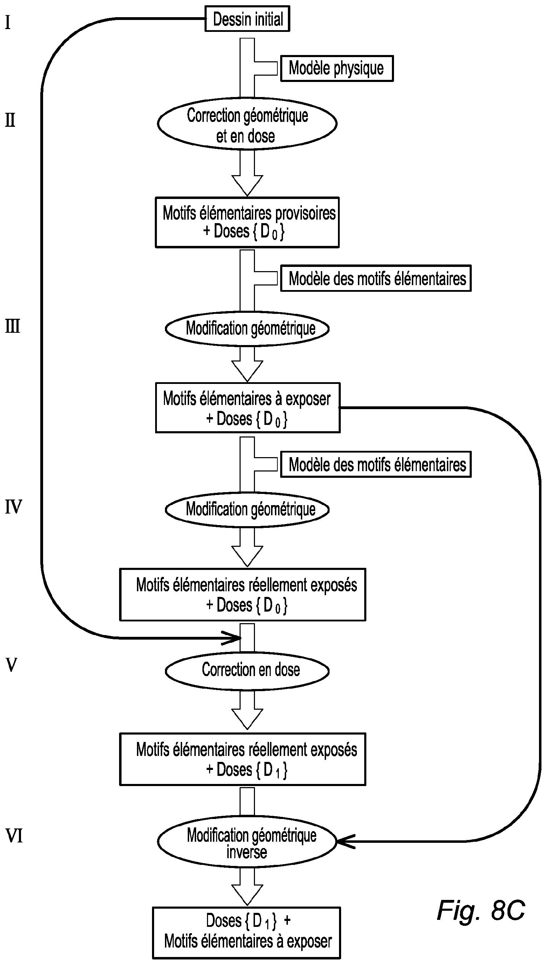

La figure 8A illustre, de manière très générale, un procédé de préparation de données selon un mode de réalisation de l'invention. Ce procédé est mis en œuvre par ordinateur. Les données fournies en entrée définissent le dessin à transférer, qui correspond par exemple à un masque de photolithographie pour la réalisation d'un circuit intégré. Comme cela a été expliqué plus haut, si on utilisait directement ce dessin « nominal » pour commander la machine VSB on n'obtiendrait pas le résultat escompté à cause d'une part des effets de proximité et d'autre part, dans certains cas, des effets liés au fractionnement en petits motifs élémentaires. Il est donc nécessaire d'appliquer des corrections géométriques et en dose d'exposition pour obtenir un dessin corrigé. Ce dessin corrigé diffère du dessin nominal mais il est tel que, lorsqu'il est utilisé pour commander la machine VSB, il aboutit au transfert sur le substrat d'un dessin « réel » qui constitue une bonne approximation (idéalement, la meilleure possible) du dessin nominal fourni en entrée. Ces corrections sont calculées en appliquant un modèle physique pour corriger les effets de proximité (ce qui est conventionnel) et un modèle des petits motifs élémentaires (ce qui constitue un apport de la présente invention).

Lorsque le modèle des petits motifs élémentaires est exprimé en termes de variation de dose (équation (4)), il fournit directement une correction de dose qui doit être prise en compte lors de l'application du modèle physique. Plus précisément, pour chaque motif élémentaire, la dose réellement appliquée via le modele des petits motifs élémentaires est de $D_0 + \Delta D$, $\Delta D$ étant fonction des paramètres géométriques. Pour corriger cet effet il suffit donc d'assigner à chaque motif élémentaire la dose $D_0 - \Delta D$.

Le cas d'un modèle des petits motifs élémentaires exprimé en termes de variations dimensionnelles (équations (2) et (3)) est plus complexe. Deux modes de réalisation seront décrits en référence aux figures 8B et 8C.

Dans le mode de la réalisation de la figure 8B :

- Un fichier informatique décrivant le dessin (« layout ») à transférer sur substrat est fourni comme donnée d'entrée (étape i).
- Les motifs constituant ce dessin sont fracturés en motifs élémentaires ayant des dimensions nominales prédéfinies, et le modèle physique est utilisé, de manière tout à fait conventionnelle, pour effectuer une première correction géométrique et en dose (étape ii). Cette correction conduit à un dessin corrigé constitué par un ensemble de motifs à exposer dont les dimensions diffèrent de celles des motifs « nominaux » fournis en entrée, et à une répartition de dose $\{D_0\}$ associée à chaque motif élémentaire.
- On applique ensuite le modèle des motifs élémentaires, de manière à déterminer la géométrie des motifs qui sont réellement exposés (étape iii).
- Les modifications géométriques affectent la répartition de dose d'une manière qui peut être calculée (étape iv). La dose $D_1$ « réelle » d'un motif élémentaire peut être reliée à la dose initiale $D_0$ par la loi de conservation de l'énergie : $D_1 = D_0(S_0/S_1)$, où $S_0/S_1$ correspond au rapport des surfaces entre un motif élémentaire initial (tenant compte uniquement des corrections destinées à compenser les effets de proximité) et le même motif tel que modifié au cours de l'étape iii.

Cette loi de conservation de l'énergie est naturelle pour garder les effets de proximité à longue portée inchangés. En effet, le champ de dose loin du motif élémentaire d'intérêt est le même dans le cas d'un changement de géométrie ou de dose respectant l'équation de conservation de l'énergie. Par contre, pour des structures petites par rapport à la variation spatiale de la PSF, par exemple de type contact, une simple application de la loi de conservation d'énergie ne fournit pas des résultats satisfaisants. Il faut donc avoir recours à une correction globale tenant compte des motifs élémentaires avoisinants. Cette correction globale de la dose des motifs élémentaires peut être réalisée à l'étape iv). Elle peut utiliser un algorithme semblable à celui mis en œuvre dans l'étape ii), mais ne modifiant que la dose et laissant la géométrie inchangée.

- La dernière étape (v) consiste à appliquer la dose $D_1$ aux motifs élémentaires « à exposer », déterminés lors de l'étape ii. Formellement, cela consiste à effectuer une transformation géométrique inverse à celle appliquée lors de l'étape iii, mais en pratique il n'est pas nécessaire de calculer cette transformation car la géométrie d'arrivée est déjà connue.

Le procédé de la figure 8C se différencie de celui de la figure 8B en ce qu'il comprend une étape (référence III sur la figure) de pré-compensation des effets des petits motifs élémentaires. Dans ce procédé :

- Un fichier informatique décrivant le dessin à transférer sur substrat, est fourni comme donnée d'entrée (étape I, équivalente à l'étape i du procédé de la figure 8B).
- Le dessin à transférer est fracturé en motifs élémentaires et le modèle physique est utilisé, de manière tout à fait conventionnelle, pour effectuer une première correction géométrique et en dose (étape II, équivalent à l'étape ii du procédé de la figure 8B). Cette correction conduit à un dessin constitué par un ensemble de motifs élémentaires dont les dimensions diffèrent de celles des motifs « nominaux » fournis en entrée, et à une répartition de dose $\{D_0\}$ associée à chaque motif élémentaire. Ces motifs élémentaires, cependant, ne sont pas ceux qui seront effectivement utilisés pour effectuer la lithographie ; on peut les qualifier de motifs élémentaires « provisoires ».

- Le modèle des motifs élémentaires est utilisé pour calculer et appliquer une correction des motifs élémentaires provisoires, de manière à obtenir les motifs à exposer (étape III). Typiquement, si un motif élémentaire « provisoire »

présente une dimension $H_0$ on prendra un motif élémentaire corrigé (« à transférer ») de dimension $H_0$-$\Delta H_0$, de telle sorte que la dimension du motif réellement transféré au substrat donnée par le modèle des motifs élémentaires sera de $H_0$. En pratique, la dimension $H_0$-$\Delta H_0$ du motif élémentaire corrigé est arrondie au plus proche multiple du pas de grille minimal d'un dessin d'entrée de la machine VSB.

- On applique ensuite le modèle des motifs élémentaires, de manière à déterminer la géométrie des motifs qui sont réellement exposés (étape IV, équivalente à l'étape iii du procédé de la figure 8B, sauf que les motifs élémentaires utilisés sont pré-corrigés).
- A ce point, la dose $D_1$ réelle est calculée comme dans l'étape iv du procédé de la figure 8B (IV),
- Puis cette dose $D_1$ est appliquée aux motifs déterminés lors de l'étape III (VI).

Dans une machine VSB, les données d'entrée peuvent être re-fracturées au niveau des bordures des zones de champs de la machine. Dans le flot standard de préparation des données, s'appuyant sur un seul modèle PSF, cette étape de post-fracturation n'altère pas la correction. En revanche, dans le cas du modèle des petits motifs élémentaires, la post-fracturation des motifs élémentaires peut conduire à des erreurs de correction. Il est donc préférable de prendre en compte cette « fracturation machine ». Cela peut être fait en introduisant une correction « en avance de phase », intégrée à l'étape ii) du procédé de la figure 8B ou à l'étape III) du procédé de la figure 8C.

Le procédé de préparation de données de la figure 8A (dont les figures 8B et 8C constituent des modes de réalisation particuliers) nécessite la prise en compte d'un modèle physique de répartition des électrons, exprimé par une fonction d'étalement du point PSF. D'une manière connue en soi, la PSF est déterminée par étalonnage à partir de motifs réalisés par lithographie VSB. Or ces motifs, surtout lorsqu'ils sont de petite taille, peuvent être affectés par les variations dimensionnelles discutées plus haut. A présent, cela n'est pas pris en compte. Ainsi, les effets des petits motifs élémentaires induisent des erreurs dans l'estimation de la PSF. A leur tour, ces erreurs affectent la précision de l'étalonnage des paramètres du modèle des motifs élémentaires. En conclusion, les deux modèles utilisés pour calculer les corrections géométriques et de dose selon un procédé du type illustré par la figure 8A sont affectés par des erreurs. Cela a tendance à augmenter l'écart entre le motif effectivement transféré sur le substrat et le motif « nominal », ou « cible ».

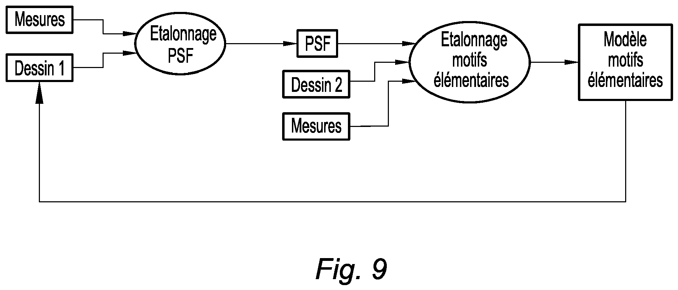

Pour pallier cet inconvénient, l'invention propose de procéder à une estimation itérative de la PSF, comme illustré par la figure 9.

Premièrement, la PSF est estimée de manière conventionnelle, en comparant la simulation d'un premier dessin « nominal » d'étalonnage (dessin 1) avec des mesures obtenues sur le dessin effectivement transféré sur un substrat. La PSF ainsi obtenue est utilisée pour effectuer un étalonnage du modèle des motifs élémentaires comme cela a été décrit en détail plus haut, à partir d'un deuxième dessin d'étalonnage (dessin 2). Le modèle des motifs élémentaires ainsi obtenu est appliqué au premier dessin d'étalonnage. Le premier dessin d'étalonnage modifié par la prise en compte des effets des petits motifs élémentaires est utilisé pour calculer une nouvelle estimation de la PSF, et ainsi de suite jusqu'à la convergence.

Une fois la préparation de données achevée, le transfert du motif sur le substrat se fait de manière conventionnelle, en utilisant les géométries et les doses calculées conformément à l'invention.

## Revendications

1. Procédé d'étalonnage de motifs élémentaires en lithographie électronique à faisceau formé comprenant les étapes suivantes :

   a. réaliser, par lithographie électronique à faisceau formé, au moins un motif d'étalonnage (MCO, MCH, MCV) comprenant des figures géométriques ayant chacune une dimension critique nominale ($CD_0$), fractionnées en motifs élémentaires (ME) de dimensions plus petites que chaque dite dimension critique nominale, les motifs élémentaires de chaque figure géométrique présentant des dimensions identiques et ceux de figures géométriques distinctes présentant des dimensions différentes ;
   b. mesurer la dimension critique réelle ($CD_m$) de chaque dite figure géométrique ; et
   c. appliquer une méthode de régression à partir des dimensions critiques réelles ainsi déterminées pour construire un modèle mathématique exprimant :

      - soit une variation de dimensions ($\Delta H$, $\Delta W$, $\Delta L$) desdits motifs élémentaires,
      - soit une erreur de dose d'exposition desdits motifs élémentaires produisant un effet équivalent à ladite variation de dimensions, en fonction des dimensions ($H_0$, $W_0$, $L_0$) des motifs élémentaires.

2. Procédé selon la revendication 1 dans lequel ladite étape c.

comprend les sous-étapes suivantes :

c1. déterminer une expression de ladite variation de dimensions desdits motifs élémentaires ou de ladite erreur de dose en fonction des dimensions des motifs élémentaires et d'une pluralité de paramètres à évaluer ;

c2. Calculer les valeurs desdits paramètres à évaluer par minimisation d'une fonction représentative d'un écart moyen entre les dimensions mesurées lors de l'étape b et celles calculées à l'aide de l'expression déterminée lors de la sous-étape c1.

3. Procédé selon l'une des revendications précédentes dans lequel les figures géométriques d'un même motif d'étalonnage sont des lignes droites parallèles entre elles.

4. Procédé selon l'une des revendications précédentes dans lequel lesdits motifs élémentaires sont choisis parmi des motifs rectangulaires et des motifs triangulaires.

5. Procédé selon l'une des revendications 1 ou 2 dans lequel lesdits motifs élémentaires sont en forme de triangle rectangle isocèle, et dans lequel les figures géométriques d'un même motif d'étalonnage sont de lignes droites parallèles entre elles et à un cathète desdits motifs élémentaires.

6. Procédé selon l'une des revendications précédentes dans lequel chaque dite forme géométrique est fractionnée en motifs élémentaires identiques, juxtaposés sans recouvrement.

7. Procédé selon l'une des revendications 1 ou 2 dans lequel lesdits motifs élémentaires sont en forme de triangle rectangle isocèle, lesdites figures géométriques sont de lignes droites parallèles entre elles et à un côté des motifs élémentaires correspondants, et ledit motif d'étalonnage comprend :

- des lignes formées de deux sous-ensembles de motifs élémentaires identiques en forme de triangle rectangle isocèle juxtaposés sans recouvrement, lesdits sous-ensembles étant superposés avec un décalage spatial ; et
- des lignes formées de motifs élémentaires en forme de triangle rectangle isocèle présentant des orientations complémentaires, juxtaposées sans recouvrement.

8. Procédé selon l'une des revendications précédentes dans lequel ledit modèle mathématique est un modèle polynomial.

9. Procédé de préparation de données pour lithographie électronique à faisceau formé comprenant une étape de correction d'une variation de dimensions d'au moins un motif élémentaire d'un dessin à transférer sur un substrat par lithographie électronique à faisceau formé, ladite étape étant mise en œuvre par l'utilisation d'un modèle mathématique exprimant ladite variation, ou une erreur de dose d'exposition produisant un effet équivalent à ladite variation, en fonction des dimensions dudit motif élémentaire ;
le procédé comprenant également une étape préalable de détermination dudit modèle mathématique au moyen d'un procédé d'étalonnage selon l'une des revendications 1 à 8.

10. Procédé de préparation de données pour lithographie électronique à faisceau formé selon la revendication 9 dans lequel ledit modèle mathématique exprime ladite variation de dimensions d'au moins un motif élémentaire en fonction de ses dimensions, le procédé comprenant les étapes suivantes :

i. recevoir, en tant que donnée d'entrée, un dessin à transférer sur un substrat par lithographie électronique à faisceau formé ;

ii. fractionner ledit dessin en motifs élémentaires et utiliser un modèle physique de répartition des électrons pour effectuer une correction géométrique et/ou en dose d'exposition de chaque dit motif élémentaire ;

iii. appliquer ledit modèle mathématique pour calculer une variation de dimensions de chaque dit motif élémentaire ;

iv. calculer, pour chaque dit motif élémentaire, une dose d'exposition corrigée en tenant compte de la variation de dimensions correspondante ; et

v. appliquer les doses d'expositions corrigées calculées lors de l'étape iv aux motifs élémentaires corrigés, tels que déterminés à l'issue de l'étape ii.

11. Procédé de préparation de données pour lithographie électronique à faisceau formé selon la revendication 9 dans lequel ledit modèle mathématique exprime ladite variation de dimensions d'au moins un motif élémentaire en fonction de ses dimensions, le procédé comprenant les étapes suivantes :

I. recevoir, en tant que donnée d'entrée, un motif géométrique à transférer sur un substrat par lithographie électronique à faisceau formé ;

II. fractionner ledit dessin en motifs élémentaires et utiliser un modèle physique de répartition des électrons pour effectuer une correction géométrique et/ou en dose d'exposition de chaque dit motif élémentaire ;

III. appliquer ledit modèle mathématique pour calculer une variation de dimensions de chaque dit motif élémentaire, et modifier lesdits motifs élémentaires pour corriger cette variation ;

IV. appliquer à nouveau ledit modèle mathématique pour calculer une nouvelle variation de dimensions de chaque dit motif élémentaire, en prenant compte la correction effectuée lors de l'étape III ;

V. calculer, pour chaque dit motif élémentaire, une dose d'exposition corrigée en tenant compte de la variation de dimensions correspondante calculée lors de l'étape IV ; et

VI. appliquer les doses d'expositions corrigées calculées lors de l'étape V aux motifs élémentaires tel que modifiés lors de l'étape III.

**12.** Procédé de préparation de données pour lithographie électronique à faisceau formé selon la revendication 9 dans lequel ledit modèle mathématique exprime une erreur de dose d'exposition produisant un effet équivalent à une variation de dimensions d'au moins un motif élémentaire de lithographie électronique en fonction de ses dimensions, le procédé comprenant une étape de correction de ladite erreur de dose d'exposition.

**13.** Procédé de transfert d'un dessin sur un substrat par lithographie électronique à faisceau formé, comprenant :

- une étape de préparation de données, mise en œuvre par un procédé selon l'une des revendications 9 à 12 ; et
- une étape de lithographie électronique à faisceau formé utilisant des dimensions et doses d'exposition de motifs élémentaires obtenues par ledit procédé.

**14.** Procédé d'estimation d'un modèle physique de répartition des électrons dans un procédé de lithographie électronique à faisceau formé, comprenant :

A. le transfert d'un dessin sur un substrat au moyen dudit procédé de lithographie électronique à faisceau formé, ledit dessin étant composé d'une pluralité de motifs élémentaires ;

B. une estimation dudit modèle physique de répartition des électrons par comparaison entre des dimensions simulées et des dimensions mesurées dudit dessin transféré sur le substrat ;

C. la mise en œuvre d'un procédé d'étalonnage selon la revendication 2 pour construire un modèle mathématique exprimant une variation des dimensions desdits motifs élémentaires en fonction desdites dimensions ; et

D. le calcul de nouvelles dimensions simulées du dessin transféré sur le substrat par application dudit modèle mathématique ; et les étapes B. à D. étant mises en œuvre de manière itérative.

**Patentansprüche**

**1.** Verfahren zum Kalibrieren von Elementarmustern in Formstrahl-Elektronenlithographie, umfassend die folgenden Schritte:

a. das Durchführen mindestens eines Kalibriermusters (MCO, MCH, MCV) durch Formstrahl-Elektronenlithographie, umfassend geometrische Figuren, die jeweils eine nominale kritische Abmessung ($CD_0$) aufweisen, und die in Elementarmustern (ME) mit kleineren Abmessungen als jede der nominalen kritischen Abmessungen unterteilt sind, wobei die Elementarmuster jeder geometrischen Figur identische Abmessungen aufweisen und die der verschiedenen geometrischen Figuren unterschiedliche Abmessungen aufweisen;

b. das Messen der tatsächlichen kritischen Abmessung ($CD_m$) jeder geometrischen Figur; und

c. das Anwenden einer Regressionsmethode aus den so bestimmten realen kritischen Abmessungen, um ein ausdrückliches mathematisches Modell zu konstruieren:

- entweder eine Veränderung der Abmessungen ($\Delta H$, $\Delta W$, $\Delta L$) der Elementarmuster,
- oder einen Fehler der Belichtungsdosis der Elementarmuster, der eine Wirkung erzeugt, die der Veränderung der Abmessungen entspricht, als Funktion der Abmessungen ($H_0$, $W_0$, $L_0$) der elementaren Muster.

**2.** Verfahren nach Anspruch 1, wobei der Schritt c. die folgenden Teilschritte umfasst:

c1. das Bestimmen eines Ausdrucks der Veränderung der Abmessungen der Elementarmuster oder des Dosisfehlers als Funktion der Abmessungen der Elementarmuster und einer Vielzahl von zu bewertenden Parametern;

c2. das Berechnen der Werte der zu bewertenden Parameter durch Minimierung einer Funktion, die eine durchschnittliche Abweichung zwischen den in Schritt b gemessenen Abmessungen und denen darstellt, die unter Verwenden des in Teilschritt c1 bestimmten Ausdrucks berechnet wurden.

3. Verfahren nach einem der vorhergehenden Ansprüche, wobei die geometrischen Figuren eines selben Kalibriermusters zueinander parallele gerade Linien sind.

4. Verfahren nach einem der vorhergehenden Ansprüche, wobei die Elementarmuster aus rechteckigen Mustern und dreieckigen Mustern ausgewählt werden.

5. Verfahren nach einem der Ansprüche 1 oder 2, wobei die Elementarmuster in Form eines gleichschenkeligen rechteckigen Dreiecks sind, und wobei die geometrischen Figuren eines selben Kalibriermusters untereinander parallele und zu einer Kathete von Elementarmustern gerade Linien sind.

6. Verfahren nach einem der vorhergehenden Ansprüche, wobei jede geometrische Form in identische, ohne Überschneidung nebeneinander angeordnete Elementarmuster unterteilt wird.

7. Verfahren nach einem der Ansprüche 1 oder 2, wobei die Elementarmuster in Form eines gleichschenkeligen rechteckigen Dreiecks sind, wobei die geometrischen Figuren zueinander parallele und zu einer Seite der entsprechenden Elementarmuster gerade Linien sind und das Kalibriermuster umfasst:

- geformte Linien der zwei Teilmengen von identischen Elementarmustern in Form eines ohne Überschneidung nebeneinander angeordneten gleichschenkeligen rechteckigen Dreiecks, wobei die Teilmengen mit einem räumlichen Versatz überlagert werden; und

- geformte Linien von Elementarmustern in Form eines gleichschenkeligen rechteckigen Dreiecks, die ohne Überschneidung nebeneinander angeordnete komplementäre Ausrichtungen aufweisen.

8. Verfahren nach einem der vorhergehenden Ansprüche, wobei das mathematische Modell ein polynomes Modell ist.

9. Verfahren zur Vorbereitung von Daten für die Formstrahl-Elektronenlithographie, umfassend einen Korrekturschritt einer Veränderung von Abmessungen mindestens eines durch die Formstrahl-Elektronenlithographie auf ein Trägermaterial zu übertragenden Elementarmusters einer Abbildung, wobei der Schritt durch Verwendung eines mathematischen Modells umgesetzt wird, das die Veränderung oder einen Fehler der Belichtungsdosis ausdrückt, die einen Wirkung erzeugt, die der Veränderung als Funktion der Abmessungen des Elementarmusters entspricht; wobei das Verfahren gleichermaßen einen der Bestimmung des mathematischen Modells mittels eines Kalibrierverfahrens nach einem der Ansprüche 1 bis 8 vorhergehenden Schritt umfasst.

10. Verfahren zur Vorbereitung von Daten für die Formstrahl-Elektronenlithographie nach Anspruch 9, wobei das mathematische Modell die Veränderung der Abmessungen mindestens eines Elementarmusters als Funktion seiner Abmessungen ausdrückt, wobei das Verfahren die folgenden Schritte umfasst:

i. das Erhalten als Eingangsdaten einer durch Formstrahl-Elektronenlithographie auf ein Trägermaterial zu übertragende Abbildung;

ii. das Aufspalten der Abbildung in Elementarmuster und das Verwenden eines physikalischen Elektronenverteilungsmodells, um eine Geometriekorrektur und/oder der Belichtungsdosis jedes der Elementarmuster auszuführen;

iii. das Anwenden des mathematischen Modells, um eine Veränderung in den Abmessungen jedes der Elementarmuster zu berechnen;

iv. das Berechnen für jedes der Elementarmuster einer korrigierten Belichtungsdosis unter Berücksichtigung der entsprechenden Veränderung der Abmessungen; und

v. das Anwenden anlässlich der in Schritt iv berechneten korrigierten Belichtungsdosen auf die korrigierten elementaren Einheiten, wie sie am Ende des Schritts ii bestimmt wurden.

11. Verfahren zur Vorbereitung von Daten für die Formstrahl-Elektronenlithographie nach Anspruch 9, wobei das mathematische Modell die Veränderung der Abmessungen mindestens eines Elementarmusters als Funktion seiner Abmessungen ausdrückt, wobei das Verfahren die folgenden Schritte umfasst:

I. das Erhalten als Eingangsdaten eines durch Formstrahl-Elektronenlithographie auf ein Trägermaterial zu übertragenden Geometriemusters;

II. das Aufspalten der Abbildung in Elementarmuster und das Verwenden eines physikalischen Elektronenverteilungsmodells, um eine Geometriekorrektur und/oder der Belichtungsdosis jedes der Elementarmuster auszuführen;

III. das Anwenden des mathematischen Modells, um eine Veränderung in den Abmessungen jedes der Elementarmuster zu berechnen, und ein Verändern der Elementarmuster, um diese Veränderung zu korrigieren;

IV. das erneutes Anwenden des mathematischen Modells, um eine erneute Veränderung der Abmessungen von jedem der Elementarmuster durch Berücksichtigen der durchgeführten Korrektur anlässlich des Schritts III zu berechnen;

V. das Berechnen für jedes der Elementarmuster einer anlässlich des Schritts IV berechneten korrigierten Belichtungsdosis unter Berücksichtigung der entsprechenden Veränderung der Abmessungen; und

VI. das Anwenden der anlässlich des Schritts V berechneten korrigierten Belichtungsdosen auf die anlässlich des Schritts III veränderten Elementarmuster.

12. Verfahren zur Vorbereitung von Daten für die Formstrahl-Elektronenlithographie nach Anspruch 9, wobei das mathematische Modell einen Fehler der Belichtungsdosis ausdrückt, der eine Wirkung entsprechend einer Veränderung der Abmessungen von mindestens einem Elementarmuster der Elektronenlithographie als Funktion ihrer Abmessungen erzeugt, wobei das Verfahren einen Korrekturschritt des Fehlers der Belichtungsdosis umfasst.

13. Verfahren zum Übertragen einer Abbildung auf ein Trägermaterial durch Formstrahl-Elektronenlithographie, umfassend:

- einen Schritt zur Vorbereitung von durch ein Verfahren nach einem der Ansprüche 9 bis 12 umgesetzten Daten, und
- einen Schritt der Formstrahl-Elektronenlithographie durch Verwenden von Abmessungen und Belichtungsdosen der durch das Verfahren erhaltenen Elementarmuster.

14. Verfahren zur Abschätzung eines physikalischen Elektronenverteilungsmodells in einem Verfahren der Formstrahl-Elektronenlithographie, umfassend:

A. das Übertragen einer Abbildung auf ein Trägermaterial mittels des Verfahrens der Formstrahl-Elektronenlithographie, wobei die Abbildung aus einer Vielzahl von Elementarmustern besteht;

B. eine Abschätzung des physikalischen Elektronenverteilungsmodells durch Vergleich zwischen simulierten Abmessungen und auf das Trägermaterial übertragenen gemessenen Abmessungen der Abbildung;

C. das Umsetzen eines Kalibrierverfahrens nach Anspruch 2, um ein mathematisches Modell aufzubauen, das eine Veränderung der Abmessungen der Elementarmuster als Funktion der Abmessungen ausdrückt; und

D. das Berechnen neuer simulierter Abmessungen der durch Anwendung des mathematischen Modells auf das Trägermaterial übertragenen Abbildung; und wobei die Schritte B. bis D. auf eine iterative Weise umgesetzt werden.

## Claims

1. Method for calibrating elementary patterns in shaped electron beam lithography, comprising the following steps:

a. producing, by means of shaped electron beam lithography, at least one calibration pattern (MCO, MCH, MCV) comprising geometric figures which each have a critical nominal dimension ($CD_0$) and which are divided into elementary patterns (ME) of smaller sizes than each nominal critical dimension, the elementary patterns of each geometric figure having identical dimensions and those of separate geometric figures having different dimensions;

b. measuring the real critical dimension ($CD_m$) of each geometric figure; and

c. applying a regression method based on the real critical dimensions determined in this manner in order to construct a mathematical model expressing:

- either a dimension variation ($\Delta H$, $\Delta W$, $\Delta L$) of the elementary patterns,

- or an exposure dose error of the elementary patterns producing an effect equivalent to the dimension variation, in accordance with the dimensions ($H_0$, $W_0$, $L_0$) of the elementary patterns.

2. Method according to claim 1, wherein the step c comprises the following substeps:

   c1 determining an expression of the dimension variation of the elementary patterns or the dose error in accordance with the dimensions of the elementary patterns and a plurality of parameters to be evaluated;
   c2 calculating the values of the parameters to be evaluated by minimising a function representative of a mean deviation between the dimensions measured during step b and those calculated using the expression determined during sub-step c1.

3. Method according to either of the preceding claims, wherein the geometric figures of the same calibration pattern are mutually parallel straight lines.

4. Method according to any one of the preceding claims, wherein the elementary patterns are selected from rectangular patterns and triangular patterns.

5. Method according to either claim 1 or claim 2, wherein the elementary patterns are in the form of an isosceles right triangle, and wherein the geometric figures of the same calibration pattern are mutually parallel straight lines and which are parallel with a cathetus of the elementary patterns.

6. Method according to any one of the preceding claims, wherein each geometric shape is divided into identical elementary patterns which are juxtaposed without overlap.

7. Method according to either claim 1 or claim 2, wherein the elementary patterns are in the form of an isosceles right triangle, the geometric figures are mutually parallel straight lines which are parallel with a side of the corresponding elementary patterns, and the calibration pattern comprises:

   - lines formed by two sub-assemblies of identical elementary patterns in the form of an isosceles right triangle, juxtaposed without overlap, the sub-assemblies being superimposed with a spatial offset; and
   - lines formed by elementary patterns in the form of an isosceles right triangle having complementary orientations which are juxtaposed without overlap.

8. Method according to any one of the preceding claims, wherein the mathematical model is a polynomial model.

9. Method for preparing data for shaped electron beam lithography comprising a step of correcting a dimension variation of at least one elementary pattern of a drawing to be transferred to a substrate by means of shaped electron beam lithography, the step being implemented by the use of a mathematical model which expresses the variation, or an exposure dose error which produces an effect equivalent to this variation, in accordance with the dimensions of the elementary pattern;
the method also comprising a prior step of determining the mathematical model using a calibration method according to any one of claims 1 to 8.

10. Method for preparing data for shaped electron beam lithography according to claim 9, wherein the mathematical model expresses the dimension variation of at least one elementary pattern in accordance with the dimensions thereof, the method comprising the following steps:

    i. receiving, as an input data item, a drawing to be transferred to a substrate by means of shaped electron beam lithography;
    ii. dividing the drawing into elementary patterns and using a physical model of the distribution of the electrons in order to carry out a geometric correction and/or an exposure dose correction of each elementary pattern;
    iii. applying the mathematical model in order to calculate a dimension variation of each elementary pattern;
    iv. calculating, for each elementary pattern, a corrected exposure dose taking into account the corresponding dimension variation; and
    v. applying the corrected exposure doses calculated during step iv to the corrected elementary patterns, as determined at the end of step ii.

11. Method for preparing data for shaped electron beam lithography according to claim 9, wherein the mathematical model expresses the dimension variation of at least one elementary pattern in accordance with its dimensions, the method comprising the following steps:

I. receiving, as an input data item, a geometric pattern to be transferred to a substrate by means of shaped electron beam lithography;

II. dividing the drawing into elementary patterns and using a physical model of the distribution of the electrons in order to carry out a geometric correction and/or exposure dose correction of each elementary pattern;

III. applying the mathematical model in order to calculate a dimension variation of each elementary pattern and modifying the elementary patterns in order to correct this variation;

IV. applying the mathematical model again in order to calculate a new dimension variation of each elementary pattern taking into account the correction carried out during step III;

V. calculating, for each elementary pattern, a corrected exposure dose taking into account the corresponding dimension variation calculated during step IV; and

VI. applying the corrected exposure doses calculated during step V to the elementary patterns, as modified during step III.

12. Method for preparing data for shaped electron beam lithography according to claim 9, wherein the mathematical model expresses an exposure dose error which produces an effect equivalent to a dimension variation of at least one electron lithography elementary pattern in accordance with the dimensions thereof, the method comprising a step of correcting the exposure dose error.

13. Method for transferring a drawing to a substrate by means of shaped electron beam lithography, comprising:

- a data preparation step, implemented using a method according to any one of claims 9 to 12; and
- a shaped electron beam lithography step using dimensions and exposure doses of the elementary patterns obtained using the method.

14. Method for estimating a physical distribution model of the electrons in a shaped electron beam lithography method, comprising:

A. the transfer of a drawing to a substrate using the shaped electron beam lithography method, the drawing being composed of a plurality of elementary patterns;

B. estimating the physical distribution model of the electrons by means of comparison between simulated dimensions and measured dimensions of the drawing transferred to the substrate;

C. implementing a calibration method according to claim 2 in order to construct a mathematical model which expresses a dimension variation of the elementary patterns in accordance with the dimensions; and

D. calculating new simulated dimensions of the drawing transferred to the substrate by applying the mathematical model; and the steps B to D being implemented in an iterative manner.

Fig. 1A          Fig. 1B

Fig. 2

*Fig. 3A*

*Fig. 3B*

*Fig. 3C*

*Fig. 4*

*Fig. 5A*

*Fig. 5B*

*Fig. 5C*

*Fig. 6A*

*Fig. 6B*

$W=CD$ | $W=CD/2$ | $W=CD/3$ | $W=CD/4$

MCV

$CD_0$ | $CD_0$ | $CD_0$ | $CD_0$

Fig. 6C

$45°$

$CD_0$

MCO

Fig. 6D

$L_0$

$+$

$L_0/2$

$=$

$CD$

Fig. 6E

Fig. 7A — $H_0 = 4nm$

Fig. 7B — $H_0 = 8nm$

Fig. 7C — $H_0 = 10m$

Fig. 7D — $H_0 = 12nm$

Fig. 7E — $H_0 = 15nm$

Dessin initial

Modèle des motifs élémentaires
Modèle physique (PSF)

Correction géométrique et en dose

Dessin corrigé

Fig. 8A

i Dessin initial

Modèle physique

ii Correction géométrique et en dose

Motifs élémentaires à exposer + Doses { $D_0$ }

Modèle des motifs élémentaires

iii Modification géométrique

Motifs élémentaires réellement exposés + Doses { $D_0$ }

iv Correction en dose

Motifs élémentaires réellement exposés + Doses { $D_1$ }

v Modification géométrique inverse

Doses { $D_1$ } + Motifs élémentaires à exposer

*Fig. 8B*

Fig. 8C

Fig. 9

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **H. C. PFEIFFER et al.** Recent Advances in Electron-Beam Lithography for the High-Volume Production of VLSI devices. *IEEE transaction on electron devices,* 1979, vol. ED-26 4, 663
- **S. NISHIMURA et al.** Evaluation of Shaping Gain Adjustment Accuracy Using Atomic Force Microscope in Variably Shaped Electron-Beam Writing Systems. *J. Appl. Phys.,* 1997, vol. 36, 7517
- **J. CHOI et al.** Requirements of e-beam size and position accuracy for photomask of sub-32 nm HP device. SPIE, 2010, vol. 7748, 774819-1
- **S. PARK et al.** Requirements of the e-beam shot quality for mask patterning of the sub-1X device. SPIE, 2016, vol. 9777, 977716-1